# EUROPÄISCHE PATENTSCHRIFT

(11) **EP 1 020 733 B1**
(45) Veröffentlichungstag und Bekanntmachung des Hinweises auf die Patenterteilung: **21.11.2007**
(21) Anmeldenummer: 00100014.0
(22) Anmeldetag: 03.01.2000
(51) Int. Cl.: G01R 31/316

(54) **Integrierte Halbleiterschaltung zur Funktionsüberprüfung von Pad-Zellen**
Integrated circuit for functional testing of bond pad cells
Circuit imprimé pour tester des cellules de plots de contact

(30) Priorität: 15.01.1999 DE 19901460
(43) Veröffentlichungstag der Anmeldung: 19.07.2000
(73) Patentinhaber: Infineon Technologies AG, 81669 München (DE)
(72) Erfinder: Daehn, Wilfried, Dr., 29227 Celle (DE)
(74) Vertreter: Hoffmann, Jörg Peter

(56) Entgegenhaltungen:
- EP-A- 0 745 859
- EP-A- 0 855 662
- US-A- 5 471 153
- US-A- 5 559 441
- US-A- 5 621 740

## Beschreibung

Die Erfindung betrifft eine integrierte Halbleiterschaltung.

Integrierte Halbleiterschaltungen weisen Pad-Zellen auf, die sich zusammensetzen aus einem Anschlußpad mit einem flächenartigen Anschlußbereich für externe Zuleitungen und einem vorgeschalteten Ausgangstreiber. Die externen Zuleitungen dienen zum Austausch von Daten oder Signalen zwischen unterschiedlichen Schaltungen oder Baugruppen, die in den Pad-Zellen integrierten Ausgangstreiber zur Ausgabe von digitalen Signalen auf die externen Zuleitungen. Diese Ausgangstreiber müssen für einen zuverlässigen Betrieb der integrierten Schaltung und der an die Schaltung angeschlossenen Baugruppen in ihrer Funktionsfähigkeit, vor allem hinsichtlich dem Übertragungsverhalten von Signalen, genau spezifizierten Anforderungen genügen.

Insbesondere im Anschluß an die Herstellung einer integrierten Schaltung ist es erforderlich, die Funktionsfähigkeit der Schaltung und damit der einzelnen Pad-Zellen zu überprüfen. Hierzu ist es üblich, zur Charakterisierung des Übertragungsverhaltens der Pad-Zellen Messungen vorzunehmen, die Aufschluß über das dynamische Verhalten einer Pad-Zelle bei verschiedenartigen Signalanregungen geben. Solche Signalanregungen sind beispielsweise sprungartige Signalübergänge von einem niedrigen auf einen hohen Signalpegel oder umgekehrt. Das Ausgangssignalverhalten der geprüften Pad-Zelle bei sprungartigen Signalanregungen ist geprägt durch dynamische Verzögerungen von Signalübergängen. Bei einer Funktionsüberprüfung wird der zeitliche Signalverlauf am Ausgang der Pad-Zelle gemessen und anschließend untersucht, ob dieses dynamische Verhalten einer Pad-Zelle innerhalb vorgegebener Toleranzen liegt. Die dazu erforderlichen Messungen zu genau definierten Zeiten müssen dabei eine hohe zeitliche Genauigkeit aufweisen, die im momentanen Entwicklungsstand im Bereich weniger 100 ps (Pikosekunden) liegt.

Diese Anforderungen an die Meßgenauigkeit erfordern einen hohen apparativen Aufwand und damit sehr aufwendige und kostspielige Testeinrichtungen. Für anderweitige Funktionstests von integrierten Schaltungen sind die beschriebenen hohen Anforderungen an die zeitliche Genauigkeit der Testeinrichtungen dagegen meist nicht erforderlich.

Die Druckschrift US 5.559.441 A betrifft einen Übertragungsleitungstreiber mit einer sich selbst anpassenden Ausgangsimpedanz. Es wird dort z.B. eine Halbleiterschaltung dargestellt, welche Ausgangs- oder Ausgabepads aufweist. Vorgesehen ist auch ein Ausgabe- oder Ausgangstreiber, welcher einem Ausgabepad vorgeschaltet ist. Zielsetzung ist, die Ausgangsimpedanz einer Übertragungsleitung anzupassen. Dazu ist ein zusätzlicher Schaltkreis vorgesehen, der einen automatischen Anpassungsprozess für die Impedanz in Bezug auf die Anschlusspadtreiber oder Ausgangstreiber realisiert. Es werden dabei Testpulse vorgesehen. Im Rahmen der Vergleichsschaltung wird die Spannungsamplitude der vorgesehenen Testpulse gemessen und mit einer Vergleichsspannung verglichen.

Die Aufgabe der vorliegenden Erfindung ist es, eine integrierte Halbleiterschaltung mit Pad-Zellen anzugeben, mit der eine Funktionsprüfung der Pad-Zellen hinsichtlich deren Übertragungsverhalten bei einem verhältnismäßig geringen apparativen Meßaufwand vornehmbar ist, und außerdem ein Verfahren anzugeben zur Durchführung der Funktionsprüfung.

Die Aufgabe wird gelöst durch eine integrierte Halbleiterschaltung gemäß Anspruch 1. Vorteilhafte Weiterbildungen und Ausgestaltungen sind in Unteransprüchen gekennzeichnet.

Die erfindungsgemäße integrierte Schaltung weist einen Signalgeber zur Erzeugung periodischer Signalfolgen auf, dessen periodisches Ausgangssignal in einem Testbetrieb einem Eingang einer zu prüfenden Pad-Zelle als Eingangssignal zugeführt ist. Durch die Beaufschlagung der Pad-Zelle mit einem periodischen Signal kann von extern eine Messung am Ausgang der Pad-Zelle im Frequenzbereich durchgeführt werden.

Zur Ausführung eines Verfahrens zur Funktionsüberprüfung in Verbindung mit der integrierten Schaltung wird eine Meßanordnung verwendet, mit der eine Messung des Frequenzspektrums durchgeführt wird, durch das das dynamische Verhalten der Pad-Zelle cha-rakterisiert werden kann. Da für eine hinreichend genaue Analyse erfahrungsgemäß die Erfassung von Oberwellen bis zur fünften Harmonischen ausreicht und der gegenseitige Frequenzabstand zwischen diesen Harmonischen relativ groß ist, können die Anforderungen an die Auflösung der Messung im Frequenzbereich und damit der apparative Aufwand der Meßeinrichtung gering gehalten werden.

Eine vorteilhafte Weiterbildung der Schaltung sieht vor, daß der Signalgeber umprogrammierbar ist zur Erzeugung verschiedener periodischer Signalfolgen. So besteht die Möglichkeit, die Messung an die Charakteristik unterschiedlich schnell schaltender Pad-Zellen anzupassen, beispielsweise durch eine Signalfolge mit geringer Periodendauer bei verhältnismäßig schnell schaltenden Ausgangstreibern und eine Signalfolge mit längerer Periodendauer bei verhältnismäßig langsam schaltenden Ausgangstreibern.

Bei mehreren zu prüfenden Pad-Zellen können die Eingänge der zu prüfenden Pad-Zellen parallel mit einem oder mehreren Anschlüssen für das Ausgangssignal des Signalgebers verbunden sein, oder seriell über beispielsweise je eine Schieberregisterzelle mit einem Anschluß für das Ausgangssignal des Signalgebers verbunden sein. So erhalten alle zu prüfenden Pad-Zellen zeitversetzt um je eine Taktperiode das gleiche Eingangssignal.

Um möglichst einfach zwischen Normalbetrieb und Testbetrieb umschalten zu können, ist es von Vorteil, je eine Multiplexerschaltung zwischen den Eingang der Pad-Zelle und den Ausgang des Signalgebers zu schalten, die beispielsweise von einer Betriebsartensteuerung gesteuert wird.

Die Erfindung wird im folgenden anhand der in der Zeichnung dargestellten Figuren näher erläutert. Es zeigen:
- Figur 1: im oberen Teil eine Anordnung zur Messung des dynamischen Verhaltens einer Pad-Zelle, im unteren Teil den beispielhaften Verlauf einer Sprungantwort am Ausgang der Pad-Zelle,
- Figur 2: eine Darstellung eines Ausgangstreibers einer Pad-Zelle mit Modellparametern,
- Figuren 3 und 4: Ausführungsbeispiele einer erfindungsgemäßen integrierten Schaltung mit mehreren zu prüfenden Pad-Zellen.

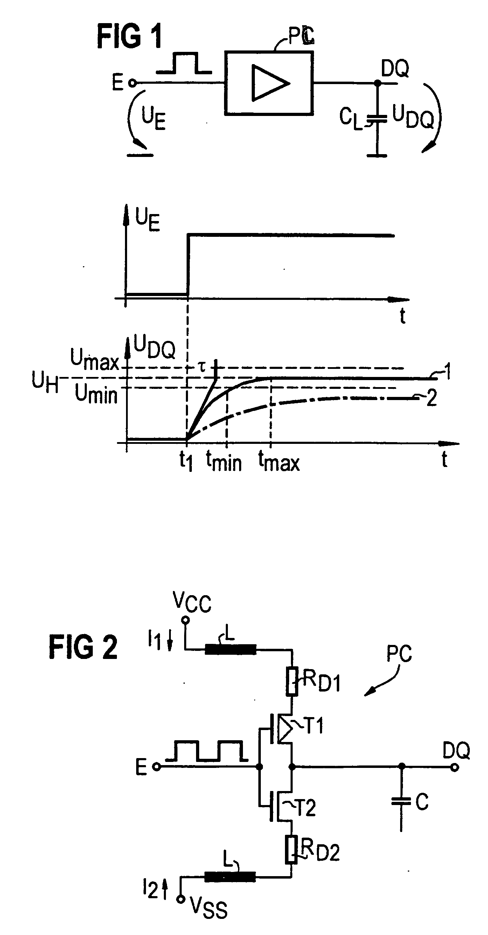

Figur 1 zeigt im oberen Teil eine Anordnung zur Funktionsprüfung einer Pad-Zelle PC einer integrierten Schaltung. Mit dieser Anordnung soll das Übertragungsverhalten des Ausgangstreibers der Pad-Zelle PC in einem Testbetrieb charakterisiert werden. Dazu wird am Eingang E der Pad-Zelle PC (Anschluß für das Eingangssignal des Ausgangstreibers) ein digitales Signal UE gleich einer Sprungfunktion von einem niedrigen Signalpegel auf einen hohen Signalpegel angelegt und der Signalverlauf des Signals U_{DQ} am Ausgang DQ der Pad-Zelle PC (Anschluß für die an das Anschlußpad anzuschließende Zuleitung) gemessen. Dieser Signalverlauf charakterisiert das dynamische Verhalten der Pad-Zelle PC, die anhand eines Ersatzschaltbildes mit Modellparametern nachgebildet werden kann. Ein beispielhaftes Schaltbild eines Ausgangstreibers einer Pad-Zelle PC mit den Modellparametern R_{D1}, R_{D2}, L, C ist in Figur 2 dargestellt.

Im unteren Teil der Figur 1 ist ein vereinfachter Verlauf der sogenannten Sprungantwort des Signals U_{DQ}, hervorgerufen durch die Sprungfunktion des Signals U_{E}, dargestellt. Der Spannungspegel des Signals U_{DQ} steigt dabei ab dem Einschaltzeitpunkt t1 nicht sprunghaft auf den Wert U_{H} im stationären Zustand an, sondern in einem dynamischen Verlauf gemäß den Werten der Modellparameter R_{D1}, R_{D2}, L, C entsprechend langsamer, charakterisiert durch die Teitkonstante τ. Deren Größe ist, wie allgemein bekannt, von den Werten der Modellparameter R_{D1}, R_{D2}, L, C abhängig.

Das Kriterium der Funktionstüchtigkeit einer Pad-Zelle PC in Figur 1 ist, daß der Spannungspegel des Signals U_{DQ} zwischen einer Mindestzeit tₘᵢₙ und einer Maximalzeit tₘₐₓ ab dem Einschaltzeitpunkt t1 einen Wert aufweist, der in dem Toleranzbereich zwischen einem Mindestwert Uₘᵢₙ und einem Maximalwert Uₘₐₓ liegt. Der Verlauf 1 des Signals U_{DQ} zeigt eine beispielhafte Sprungantwort einer funktionstüchtigen Pad-Zelle PC. Der Verlauf 2 des Signals U_{DQ} zeigt eine beispielhafte Sprungantwort einer fehlerhaften Pad-Zelle PC. Die Zeitdauer zwischen tₘᵢₙ und tₘₐₓ beträgt im momentanen Entwicklungsstand wenige 100 ps, das bedeutet, es werden vergleichsweise hohe Anforderungen an die Meßgenauigkeit der Meßapparatur gestellt. Diese haben die eingangs bereits erwähnten Konsequenzen insbesondere hinsichtlich hoher Anschaffungskosten.

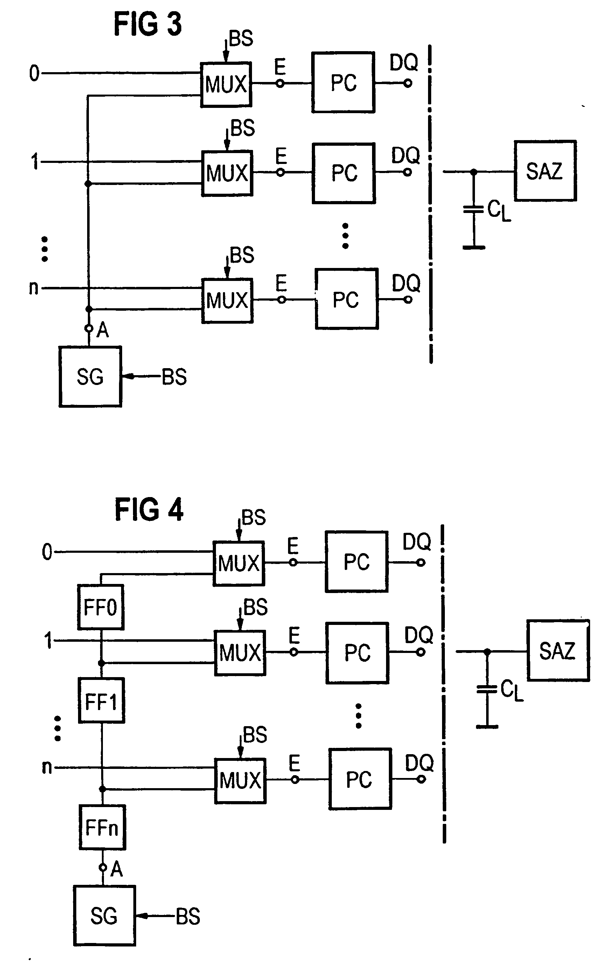

Figur 3 zeigt eine Schaltungsanordnung mit einem Signalgeber SG zur Erzeugung periodischer Signalfolgen. Werden die Pad-Zellen PC an deren Eingänge E mit einer periodischen Signalfolge stimuliert, ist an deren Ausgängen DQ ebenfalls ein periodischer Verlauf der Ausgangssignale U_{DQ} zu beobachten, der sich je nach Beschaffenheit des Eingangssignals zusammensetzt aus einem Gleichanteil, einer Grundwelle und Oberwellen. Dieser Verlauf kann in einem Meßverfahren mit einer an dem Ausgang DQ von extern angeschlossenen Meßanordnung SAZ, die zur Durchführung einer Spektralanalyse geeignet ist, beispielsweise mit einem sogenannten Spektralanalysator, gemessen werden und durch eine Analyse des aufgenommenen Frequenzspektrums charakterisiert werden.

Je nach erforderlicher Genauigkeit der Überprüfung des Übertragungsverhaltens wird ein mehr oder weniger detailliertes Ersatzschaltbild der zu prüfenden Pad-Zelle PC erstellt mit je nach Detaillierungsgrad mehr oder weniger verschiedenartigen Modellparametern. In dem Beispiel nach Figur 2 wurde die Pad-Zelle PC durch die Modellparameter R_{D1}, R_{D2}, L und C charakterisiert. Die Widerstände R_{D1} und R_{D2} modellieren dabei die Durchlaßwiderstände der Schalttransistoren T1 und T2, L die Zuleitungsinduktivitäten und C die Leitungskapazitäten. Bei einer an die Messung anschließenden Auswertung werden anhand des Frequenzspektrums, das den Amplitudengang und/oder den Phasengang umfaßt, in bekannter Weise (beispielsweise mittels einer Fourieranalyse) nacheinander die Werte der vorher aufgestellten Modellparameter der Pad-Zelle PC bestimmt und daraus die Sprungantwort der Pad-Zelle PC berechnet, die Aufschluß darüber gibt, ob das Kriterium für die Funktionsfähigkeit eingehalten ist. Es ist in dem Zusammenhang auch möglich, die Sprungantwort mit den bekannten Analyseverfahren direkt anhand des Frequenzspektrums zu eruieren, ohne vorher ein Ersatzschaltbild mit Modellparametern aufzustellen.

Die Anzahl der zu ermittelnden Harmonischen des Frequenzspektrums richtet sich im wesentlichen nach der Anzahl der aufgestellten Modellparameter. Je mehr Modellparameter bestimmt werden müssen, desto höher die Anzahl der zu erfassenden Oberwellen. Diese werden beginnend mit der Grundwelle in aufsteigender Reihenfolge erfaßt, und es wird der Amplitudengang und/oder Phasengang aufgezeichnet. Erfahrungsgemäß reicht die Ermittlung bis zur fünften Harmonischen für eine ausreichende Genauigkeit aus. Da nur diese Oberwellen erfaßt werden, deren gegenseitiger Frequenzabstand im Vergleich zu den Oberwellen ab der fünften Harmonischen relativ groß ist, bleibt der Aufwand der Meßapparatur hinsichtlich der Frequenzselektivität relativ gering und ist damit deutlich kleiner als bei einer beschriebenen Messung im Zeitbereich. Die Sprungantwort berechnet sich durch die Zeitkonstante τ, die mit den Werten der Modellparameter berechnet wird.

Bei verhältnismäßig langsam schaltenden Pad-Zellen PC können die Leitungsinduktivität L sowie die Lastkapazität CL und Leitungskapazität C gegenüber den Durchlaßwiderständen R_{D1}, R_{D2} der Transistoren T1 und T2 vernachlässigt werden. Dadurch kann die Messung im Frequenzbereich ersetzt werden durch eine einfache Gleichstrommessung am Ausgang DQ. Aus den Werten der Versorgungsspannung VCC bzw. VSS und den Strömen I1 und I2 lassen sich die Widerstände R_{D1} bzw. R_{D2} berechnen und damit, wie oben erwähnt, die Sprungantwort des Signals U_{DQ}. Zur Durchführung dieser Messung ist es jedoch erforderlich, die Periodendauer des stimulierenden Eingangssignals UE zu vergrößern, so daß je Messung der Ströme I1 und I2 ein quasistationärer Zustand am Ausgang DQ entsteht. Die Umstellung der Periodendauer des Signals UE kann beispielsweise durch Umprogrammierung des Signalgebers SG durch ein externes Steuersignal BS einer Betriebsartensteuerung geschehen.

Aus Figur 3 ist anhand eines Ausführungsbeispieles der erfindungsgemäßen Schaltung erkennbar, daß die Eingänge E mehrerer zu prüfender Pad-Zellen PC parallel mit einem Anschluß A für das periodische Ausgangssignal des Signalgebers SG verbunden sind. Es ist auch eine Variante denkbar, daß bei mehreren vorhandenen Ausgängen A des Signalgebers SG jeder einzelne parallel mit je einem der Eingänge E der Pad-Zelle PC verbunden ist.

Um zwischen dem Testbetrieb zur Funktionsprüfung der Pad-Zellen PC als einer ersten Betriebsart der integrierten Schaltung und einem Normalbetrieb als einer zweiten Betriebsart der integrierten Schaltung umzuschalten, ist zwischen dem Ausgang des Signalgebers SG und je einem Anschluß E für das Eingangssignal der Pad-Zellen PC eine Multiplexerschaltung MUX vorgesehen, die beispielsweise auch von dem Signal BS einer Betriebsartensteuerung gesteuert wird. Ein weiterer Eingang der Multiplexerschaltung MUX neben dem ersten Eingang, an dem das Ausgangssignal des Signalgebers SG anliegt, ist jeweils für ein im Normalbetrieb auszugebendes Signal 0 bis n einer anderen Funktionseinheit der integrierten Schaltung vorgesehen.

Figur 4 zeigt ein weiteres Ausführungsbeispiel der erfindungsgemäßen Schaltung. Hier sind die Anschlüsse E für die Eingangssignale mehrerer zu prüfender Pad-Zellen PC seriell über jeweils eine taktgesteuerte Schieberegisterzelle FF0 bis FFn mit einem Anschluß A für das Ausgangssignal des Signalgebers SG verbunden. Dadurch liegt an jeder Pad-Zelle PC zeitversetzt um je eine Taktperiode der Schieberegisterzellen FF0 bis FFn das periodische Ausgangssignal des Signalgebers SG an. Dieses Ausführungsbeispiel ist vorteilhaft bei Schaltungen, bei denen die Pad-Zellen PC zu anderweitigen Zwecken bereits über Schieberegisterzellen FF0 bis FFn miteinander verbunden sind (z. B. bei Leiterplatten mit "Boundary scan").

Die Schieberegisterzellen FF0 bis FFn und der Signalgeber SG lassen sich beispielsweise mit taktgesteuerten bistabilen Kippstufen realisieren. Beim Signalgeber SG kann es sich beispielsweise um ein T-Flipflop mit festbeschaltetem Eingang handeln, die Schieberegisterzellen FF0 bis FFn lassen sich beispielsweise mit D-Flipflops realisieren. Der Signalgeber SG und die Schieberegisterzellen FF0 bis FFn werden sinnvollerweise vom gleichen Takt gesteuert. Die T-Flipflops sind, wie oben beschrieben, vorteilhafterweise so ausgeführt, daß die jeweiligen periodischen Ausgangssignale durch Umprogrammierung verändert werden können.

## Patentansprüche

1. Integrierte Halbleiterschaltung mit einer oder mehreren Pad-Zellen (PC), die jeweils ein Anschlusspad und einen vorgeschalteten Ausgangstreiber umfassen und die in einer ersten Betriebsart der Schaltung anhand einer Funktionsprüfung kontrollierbar sind,
- bei welcher die Schaltung einen Signalgeber (SG) zur Erzeugung periodischer Signalfolgen aufweist, bei dem ein Anschluss (A) für ein periodisches Ausgangssignal mit dem Anschluss (E) für ein Eingangssignal einer zu prüfenden Pad-Zelle (PC) verbunden ist zur Überprüfung des Übertragungsverhaltens der Pad-Zelle (PC) in der ersten Betriebsart,
- bei welcher die Anschlüsse (E) für die Eingangssignale der zu prüfenden Pad-Zellen (PC) über jeweils eine Multiplexerschaltung (MUX) mit einem Anschluss (A) für das Ausgangssignal des Signalgebers (SG) verbunden sind zum Umschalten zwischen der ersten Betriebsart und einer zweiten Betriebsart der Schaltung,
- bei welcher ein Ausgang der Multiplexerschaltung (MUX) mit dem Anschluss (E) für das Eingangssignal einer zu prüfenden Pad-Zelle (PC) verbunden ist,
- bei welcher ein Eingang der Multiplexerschaltung (MUX) mit einem Anschluss (A) für das Ausgangssignal des Signalgebers (SG) verbunden ist,
- bei welcher ein weiterer Eingang der Multiplexerschaltung (MUS) mit einem Anschluss für ein Signal (0; n) einer anderen Funktionseinheit der integrierten Schaltung verbunden ist und
- bei welcher am Ausgang der Multiplexerschaltung (MUX) in der ersten Betriebsart der Schaltung das Ausgangssignal des Signalgebers (SG) anliegt, in der zweiten Betriebsart das Signal (0; n) der anderen Funktionseinheit der integrierten Schaltung.

2. Integrierte Halbleiterschaltung nach Anspruch 1,
**dadurch gekennzeichnet,**
**dass** der Signalgeber (26) umprogrammierbar ist zur Erzeugung verschiedener periodischer Signalfolgen.

3. Integrierte Halbleiterschaltung nach einem der vorhergehenden Ansprüche,
**dadurch gekennzeichnet,**
**dass** die Anschlüsse (E) für die Eingangssignale mehrerer zu prüfender Pad-Zellen (PC) parallel mit einem oder mehreren Anschlüssen (A) für das Ausgangssignal des Signalgebers (SG) verbunden sind.

4. Integrierte Halbleiterschaltung nach einem der Ansprüche 1 oder 2,
**dadurch gekennzeichnet,**
**dass** die Anschlüsse (E) für die Eingangssignale mehrerer zu prüfender Pad-Zellen (PC) seriell über jeweils eine Schieberegisterzelle (FF0; FFn) mit einem Anschluss (A) für das Ausgangssignal des Signalgebers (SG) verbunden sind.

5. Integrierte Halbleiterschaltung nach einem der vorhergehenden Ansprüche,
**dadurch gekennzeichnet,**
**dass** der Signalgeber (SG) eine taktgesteuerte bistabile Kippstufe vom Typ T-Flipflop enthält.

## Claims

1. Integrated semiconductor circuit having one or more pad cells (PC) which each comprise a connecting pad and an upstream output driver and which can be monitored in a first operating mode of the circuit by a functional test,
- in which the circuit has a signal transmitter (SG) in order to produce periodic signal sequences, in which a connection (A) for a periodic output signal is connected to the connection (E) for an input signal of a pad cell (PC) to be tested, in order to test the transmission response of the pad cell (PC) in the first operating mode,
- in which the connections (E) for the input signals of the pad cells (PC) to be tested are connected via in each case one multiplexer circuit (MUX) to a connection (A) for the output signal from the signal transmitter (SG) in order to switch over between the first operating mode and the second operating mode of the circuit,
- in which one output of the multiplexer circuit (MUX) is connected to the connection (E) for the input signal of a pad cell (PC) to be tested,
- in which one input of the multiplexer circuit (MUX) is connected to a connection (A) for the output signal from the signal transmitter (SG),
- in which a further input of the multiplexer circuit (MUS) is connected to a connection for a signal (0; n) of another functional unit in the integrated circuit, and
- in which in the first operating mode of the circuit, the output signal from the signal transmitter (SG) is present at the output of the multiplexer circuit (MUX), and in the second operating mode, the signal (0; n) from the other functional unit of the integrated circuit is present at the output of the multiplexer circuit (MUX).

2. Integrated semiconductor circuit according to Claim 1,
**characterized in that** the signal transmitter (26) can be reprogrammed in order to produce different periodic signal sequences.

3. Integrated semiconductor circuit according to one of the preceding claims,
**characterized in that** the connections (E) for the input signals of a plurality of pad cells (PC) to be tested are connected in parallel to one or more connections (A) for the output signal from the signal transmitter (SG).

4. Integrated semiconductor circuit according to one of Claims 1 or 2,
**characterized in that** the connections (E) for the input signals of a plurality of pad cells (PC) to be tested are connected in series via in each case one shift register cell (FFO; FFn) to a connection (A) for the output signal from the signal transmitter (SG).

5. Integrated semiconductor circuit according to one of the preceding claims,
**characterized in that** the signal transmitter (SG) contains a clock-controlled bistable multivibrator of the T-flipflop type.

## Revendications

1. Circuit intégré à semi-conducteur ayant une ou plusieurs cellules de plot (PC), qui comprennent respectivement un plot de connexion et un étage de sortie en amont et qui peuvent être contrôlés dans un premier mode de fonctionnement du circuit au moyen d'un contrôle de fonction,
- dans lequel le circuit a un générateur (SG) de signal pour produire des trains de signaux périodiques, dans lequel une borne (A) pour un signal périodique de sortie est reliée à la borne (E) pour un signal d'entrée d'une cellule de plot (PC) à contrôler pour le contrôle de la propriété de transmission de la cellule de plot (PC) dans le premier mode de fonctionnement,
- dans lequel les bornes (E) pour les signaux d'entrée des cellules de plot (PC) à contrôler sont reliées par respectivement un circuit (MUX) de multiplexage à une borne (A) pour le signal de sortie du générateur (SG) de signal pour la commutation entre le premier mode de fonctionnement et un deuxième mode de fonctionnement du circuit,
- dans lequel une sortie du circuit (MUX) de multiplexage est reliée à la borne (E) pour le signal d'entrée d'une cellule de plot (PC) à contrôler,
- dans lequel une entrée du circuit (MUX) de multiplexage est reliée à une borne (A) pour le signal de sortie du générateur (SG) de signal,
- dans lequel une autre entrée du circuit (MUX) de multiplexage est reliée à une borne pour un signal (0 ; n) d'une autre unité fonctionnelle du circuit intégré et
- dans lequel à la sortie du circuit (MUX) de multiplexage s'applique dans le premier mode de fonctionnement du circuit le signal de sortie du générateur (SG) de signal? dans le deuxième mode de fonctionnement le signal (0 ; n) de l'autre unité fonctionnelle du circuit intégré.

2. Circuit intégré à semi-conducteur suivant la revendication 1, **caractérisé**
**en ce que** le générateur (26) de signal peut être reprogrammé pour la production de divers trains périodiques de signaux.

3. Circuit intégré à semi-conducteur suivant l'une des revendications précédentes,
**caractérisé**
**en ce que** les bornes (E) pour les signaux d'entrée de plusieurs cellules de plots (PC) à contrôler sont reliées en parallèle à une ou plusieurs bornes (A) pour le signal de sortie du générateur (SG) de signal.

4. Circuit intégré à semi-conducteur suivant l'une des revendications 1 ou 2,
**caractérisé**
**en ce que** les bornes (E) pour les signaux d'entrée de plusieurs cellules de plots (PC) à contrôler sont reliées en série par respectivement une cellule (FF0 ; FFn) de registre à décalage à une borne (A) pour le signal de sortie du générateur (SG) de signal.

5. Circuit intégré à semi-conducteur suivant l'une des revendications précédentes,
**caractérisé**
**en ce que** le générateur (SG) de signal comporte un étage de bascule bistable commandé en cadence du type flip-flop T.
